# EUROPEAN PATENT APPLICATION

(11) **EP 4 016 982 A1**
(43) Date of publication of application: **22.06.2022**
(21) Application number: 20852137.7
(22) Date of filing: 14.08.2020
(51) Int. Cl.: H04N 5/225

(54) **BASE, CAMERA MODULE, AND ELECTRONIC DEVICE**

(30) Priority: 14.08.2019 CN 201921320024 U
(71) Applicant: Ofilm Group Co., Ltd., Shenzhen, Guangdong 518106 (CN); Nanchang O-FILM Optical-Electronic Tech Co., LTD., Nanchang, Jiangxi 330013 (CN)
(72) Inventor: MA, Zhongke, Shenzhen, Guangdong 518106 (CN); CHEN, Xiaofeng, Shenzhen, Guangdong 518106 (CN); SHEN, Chengzhe, Shenzhen, Guangdong 518106 (CN)
(74) Representative: Inchingalo, Simona
(86) International application number: PCT/CN2020/109055
(87) International publication number: WO 2021/027905

(57) **Abstract**

The present application relates to a base (10), a camera module (100), and an electronic device (1000). The base (10) is used for bearing a lens (20), and comprises: a substrate (1) connected to the lens (20), the substrate (1) being provided with a mounting hole (13); an optical sensing chip (2) provided in the mounting hole (13) and opposite to the lens (20), a gap (6) being provided between a sidewall (21) of the optical sensing chip (2) and an inner wall (131) of the mounting hole (13); and a connection structure (3) provided in the gap (6) and connected to the optical sensing chip (2) and the substrate (1) respectively to fix the optical sensing chip (2) to the substrate (1).

## Description

### CROSS-REFERENCE TO RELATED APPLICATIONS

This application claims to the priority of Chinese Patent Application No. 201921320024.X, filed on August 14, 2019, entitled "BASE, CAMERA MODULE AND ELECTRONIC DEVICE", the entire contents of which is incorporated herein by reference.

### TECHNICAL FIELD

The present application relates to the technical field of camera lenses, in particular to a base, a camera module and an electronic device.

### BACKGROUND

Camera modules are currently one of the hotspots in the field of consumer electronics, and are widely used in terminal electronic devices such as smartphones and tablet computers. In order to meet the needs of consumers, terminal electronic devices such as smartphones and tablet computers are developing towards thinning, which in turn requires camera modules to be developed towards thinning.

Currently, there is still a need to reduce a thickness of the camera module.

### SUMMARY

Accordingly, the present application provides a base, a camera module and an electronic device.

A base is configured to carry a lens, and includes: a substrate configured to be connected to the lens, and provied with a mounting hole; a photosensitive chip provided in the mounting hole, and opposed to the lens, wherein a gap is formed between a sidewall of the photosensitive chip and an inner wall of the mounting hole; and a connecting structure provided in the gap, and connected to the photosensitive chip and the substrate, respectively, so as to fix the photosensitive chip on the substrate.

In the base according to the embodiment of the present application, the photosensitive chip is provided in the mounting hole of the substrate, which can reduce the total thickness of the substrate and the photosensitive chip, thereby reducing the thickness of the entire camera module. Meanwhile, the sidewall of the photosensitive chip is connected to the substrate through the connecting structure, and thus there is no need to provide the reinforcing steel plate at the bottom of the substrate, which can further reduce the thickness of the camera module.

In an embodiment, the substrate includes a first surface and a second surface away from each other. The second surface is configured to be connected to the lens. The mounting hole is provided on the second surface and extends toward the first surface.

In an embodiment, the photosensitive chip includes an upper surface and a lower surface away from each other. The upper surface is opposed to the lens. A distance between the lower surface and the second surface is less than or equal to a depth of the mounting hole. The distance between the lower surface and the second surface is greater than or equal to a distance between the upper surface and the lower surface.

In an embodiment, the distance between the inner wall of the mounting hole and the sidewall of the photosensitive chip gradually decreases in a direction from the second surface to the first surface.

In an embodiment, a thickness of the substrate is greater than or equal to a thickness of the photosensitive chip.

In an embodiment, the substrate includes a first surface and a second surface away from each other. The mounting hole extends from the second surface to the first surface.

In an embodiment, the inner wall of the mounting hole is provided with a first limiting structure, and a sidewall of the photosensitive chip is provided with a second limiting structure. The first limiting structure cooperates with the second limiting structure to define a position of the photosensitive chip relative to the substrate in a circumferential direction of the mounting hole.

In an embodiment, a shape of the mounting hole matches a shape of the photosensitive chip.

In an embodiment, the connecting structure is a cured glue block filled in the gap.

In an embodiment, the photosensitive chip and the mounting hole are coaxially arranged.

In an embodiment, the substrate is a printed circuit board (PCB). The printed circuit board is provided with a first electrode pin. The photosensitive chip is provided with a second electrode pin. The first electrode pin is electrically connected to the second electrode pin though a metal wire.

In an embodiment, the base further includes an optical filter attached to the photosensitive chip.

In an embodiment, the base further includes a support provided on the base and configured to connect the lens and the substrate.

In an embodiment, the support is provided with a first positioning structure, and the substrate is provided with a second positioning structure. The first positioning structure cooperates with the second positioning structure, so as to define a mounting position of the support on the substrate.

In an embodiment, the support is a hollow structure with openings at both ends. The substrate is provided with a groove, and the support is mounted in the groove. An end of the support located in the groove is the first positioning structure, and the groove is the second positioning structure.

In an embodiment, the base further includes a packaging body formed on the substrate and configured to connect the lens and the substrate.

In an embodiment, the packaging body covers an edge of the photosensitive chip.

In an embodiment, the packaging body and the connecting structure are integrally formed.

A camera module includes a lens and a base according to any one of the embodiments. The base is connected to the lens.

An electronic device includes a camera module as described above.

### BRIEF DESCRIPTION OF THE DRAWINGS

FIG. 1 is a schematic cross-sectional view of a conventional cameral module according to an embodiment.
FIG. 2 is a schematic cross-sectional view of a cameral module according to a first embodiment.
FIG. 3 is a schematic cross-sectional view of a substrate of a camera module cooperating with a photosensitive chip according to a first embodiment.
FIG. 4 is a top view of a substrate of a camera module cooperating with a photosensitive chip according to a first embodiment.
FIG. 5 is a cross-sectional view taken along a line C-C in FIG. 4.
FIG. 6 is a cross-sectional view of a support of a camera module cooperating with a substrate according to a second embodiment.
FIG. 7 is a schematic cross-sectional view of a camera module according to a third embodiment.
FIG. 8 is a schematic view of an electronic device according to an embodiment.

### DETAILED DESCRIPTION OF THE EMBODIMENTS

In order to make the above objects, features and advantages of the present application more clearly understood, the specific embodiments of the present application will be described in detail below with reference to the accompanying drawings. In the following description, numerous specific details are set forth in order to provide a thorough understanding of the present application. However, the present application can be implemented in many other ways different from those described herein, and those skilled in the art can make similar improvements without departing from the connotation of the present application. Therefore, the present application is not limited by the specific embodiments disclosed below.

It should be noted that when an element is referred to as being "fixed to" another element, it can be directly on another element or an intermediate element may also be present. When an element is referred to as being "connected to" another element, it can be directly connected to another element or an intermediate element may be present at the same time.

Unless otherwise defined, all technical and scientific terms used herein have the same meaning as commonly understood by one of ordinary skill in the technical field to which this application belongs. The terms used herein in the specification of the application are for describing specific embodiments only, and are not intended to limit the application.

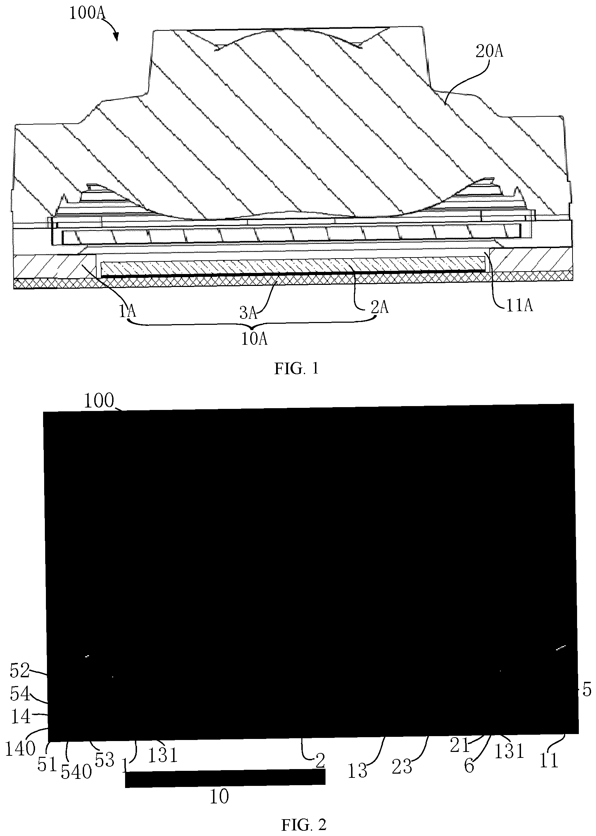

As shown in FIG. 1, a camera module 100A generally includes two parts, i.e., a base 10A and a lens 20A. The base 10A includes a substrate 1A, a photosensitive chip 2A and a reinforcing steel plate 3A. In order to make the camera module 100A thinner, the substrate 1A is provided with a hollow structure 11A. The reinforcing steel plate 3A is attached to the substrate 1A and is opposed to the hollow structure 11A. The photosensitive chip 2A is provided in the hollow structure 11A and is adhered to the reinforcing steel plate 3A by glue.

Although this configuration can reduce the thickness of the camera module 100A to a certain extent, a size of the camera module 100A in the thickness direction includes a thickness of the reinforcing steel plate 3A in addition to sizes of the lens 20A, the substrate 1A and other components, which still cannot satisfy people's requirements for thinner camera modules.

As shown in FIG. 2, the camera module 100 according to this embodiment mainly includes a base 10 and a lens 20. The base 10 is configured to carry the lens 20. In this embodiment, the base 10 includes a substrate 1, a photosensitive chip 2, a connecting structure 3, an optical filter 4, and a support 5. The photosensitive chip 2 is connected to the substrate 1 through the connecting structure 3, and the substrate 1 is connected to the lens 20 through the support 5.

Specifically, in this embodiment, the substrate 1 is a printed circuit board (PCB). The substrate 1 includes a first surface 11 and a second surface 12 away from each other, and a mounting hole 13. The second surface 12 is configured to be connected to the lens 20. The mounting hole 13 is provided on the second surface 12 of the substrate 1 and extends toward the first surface 11. The mounting hole 13 may be a blind via or a through hole. In order to facilitate production and processing, in this embodiment, the mounting hole 13 extends from the second surface 12 to the first surface 11. The photosensitive chip 2 is provided in the mounting hole 13 and is opposed to the lens 20. A gap 6 is formed between a sidewall 21 of the photosensitive chip 2 and an inner wall 131 of the mounting hole 13. The connecting structure 3 is provided in the gap 6 formed between the sidewall 21 of the photosensitive chip 2 and the inner wall 131 of the mounting hole 13, so as to fix the photosensitive chip 2 on the substrate 1. In addition, in this embodiment, a shape of the mounting hole 13 matches a shape of the photosensitive chip 2. For example, the photosensitive chip 2 is of a rectangular structure, and the mounting hole 13 is a rectangular hole.

In this embodiment, assuming that the substrate 1 is placed horizontally, the second surface 12 is then parallel to a horizontal plane, and an optical axis of the lens 20 is perpendicular to the horizontal plane. In this embodiment, the photosensitive chip 2 is provided in the mounting hole 13, such that the space occupied by the substrate 1 in the vertical direction (i.e., in a direction of the optical axis) can be effectively utilized, and a thickness of the photosensitive chip 2 and the substrate 1 after assembly can be reduced. Therefore, a size of the entire camera module 100 in the vertical direction can be reduced, that is, the thickness of the camera module 100 can be reduced. Meanwhile, in this embodiment, the connecting structure 3 is provided in the gap 6 between the sidewall of the photosensitive chip 2 and the inner wall of the mounting hole 13, which can effectively utilize the space occupied by the substrate 1 in the horizontal direction, thus avoiding increasing the size of the camera module 100 in the vertical direction due to the connection between the photosensitive chip 2 and the substrate 1. Compared with the conventional design (as shown in FIG. 1), the reinforcing steel plate can be omitted in this embodiment, so as to further reduce the thickness of the camera module 100.

In this embodiment, the connecting structure 3 is a cured glue block filled in the gap 6, that is, the connecting structure 3 is formed by curing the glue filled in the gap 6. In other embodiments, the connecting structure 3 can also be provided in other ways, for example, the connecting structure 3 can be a double-sided tape or the like provided in the gap 6.

As shown in FIG. 2, in this embodiment, the photosensitive chip 2 includes an upper surface 22 and a lower surface 23 away from each other. The upper surface 22 is opposed to the lens 20, and is configured to receive light transmitted from the lens 20. In addition, a thickness of the substrate 1 is greater than a thickness of the photosensitive chip 2. That is, a distance between the first surface 11 and the second surface 12 is greater than or equal to a distance between the upper surface 22 and the lower surface 23. In addition, in this embodiment, the photosensitive chip 2 does not protrude from the mounting hole 13. That is, a depth of the mounting hole 13 is greater than or equal to the thickness of the photosensitive chip 2, and the distance between the lower surface 23 and the second surface 12 is less than or equal to the depth of the mounting hole 13, the distance between the lower surface 23 and the second surface 12 is greater than or equal to the thickness of the photosensitive chip 2. That is, in this embodiment, the photosensitive chip 2 is entirely located in the mounting hole 13, which can increase the area of the opposed portions of the sidewall 21 of the photosensitive chip 2 and the inner wall 131 of the mounting hole 13, thereby increasing the contacting area between the sidewall 21 of the photosensitive chip 2 and the connecting structure 3, thereby improving the connection strength between the photosensitive chip 2 and the substrate 1.

Further, in this embodiment, the sidewall 21 of the photosensitive chip 2 is not in contact with the inner wall 131 of the mounting hole 13. That is, the gap 6 is formed between the periphery of the sidewall 21 of the photosensitive chip 2 and the inner wall 131 of the mounting hole 13. In this way, the contacting area between the connecting structure 3 and the photosensitive chip 2 can also be increased, and the connection strength between the photosensitive chip 2 and the substrate 1 can be improved. Meanwhile, in this embodiment, the photosensitive chip 2 and the mounting hole 13 are coaxially arranged, such that the gap 6 between the sidewall 21 of the photosensitive chip 2 and the inner wall 131 of the mounting hole 13 has the same size everywhere, such that the connecting structure 3 around the photosensitive chip 2 can have the same thickness. In this way, after the base 10 is assembled, the connecting portion between the photosensitive chip 2 and the substrate 1 has the connection strength everywhere, which enhances the damage resistance of the base 10 and improves the service life of the base 10.

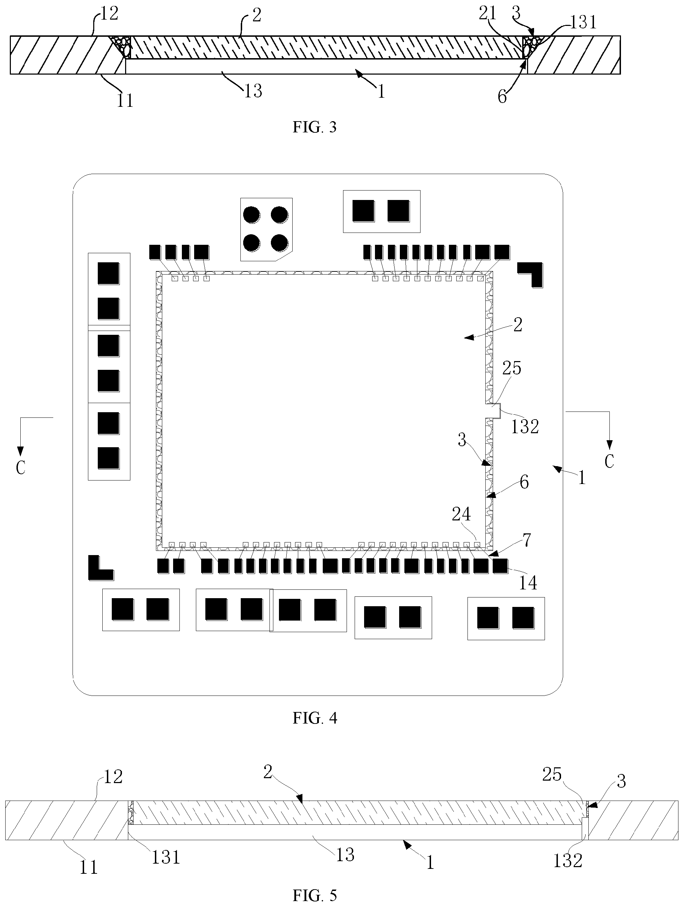

As shown in FIG. 3, in a preferred implementation of this embodiment, the distance between the inner wall 131 of the mounting hole 13 and the sidewall 21 of the photosensitive chip 2 gradually decreases in a direction from the second surface 12 to the first surface 11. That is, the mounting hole 13 is funnel-shaped, which not only facilitates placing the photosensitive chip 2 in the mounting hole 13, but also prevents the spill of the glue from contaminating the photosensitive chip 2 when applying the glue into the gap 6. Meanwhile, the mounting holes 13 are provided in this way, such that the connecting structure 3 formed by curing the glue is tapered or trapezoidal, which can serve as a wedge when cooperating with the mounting holes 13, such that the photosensitive chip 2 can be better carried.

In addition, as shown in FIG. 4, in this embodiment, the substrate 1 (i.e., the PCB) is provided with first electrode pins 14, and the photosensitive chip 2 is provided with second electrode pins 24. The first electrode pins 14 are electrically connected to the second electrode pins 24 though metal wires 7 (such as gold wires), so as to realize power supply and data transmission between the substrate 1 and the photosensitive chip 2.

As shown in FIGS. 4 and 5, in this embodiment, the inner wall 131 of the mounting hole 13 is provided with a first limiting structure 132, and the sidewall 21 of the photosensitive chip 2 is provided with a second limiting structure 25. The first limiting structure 132 cooperates with the second limiting structure 25, such that a position of the photosensitive chip 2 relative to the substrate 1 in a circumferential direction of the mounting hole 13 can be defined, such that the photosensitive chip 2 can be mounted more accurately, and such that the first electrode pins 14 corresponds to the respective second electrode pins 24 more accurately, and which is more convenient to electrically connect the first electrode pins 14 to the second electrode pins 24 through the metal wires 7.

Specifically, in this embodiment, the first limiting structure 132 is a mounting groove provided on the inner wall of the mounting hole 13. The mounting groove is provided on the second surface 12 and extends toward the first surface 11. For the convenience of production, the mounting groove extends to the first surface 11. The second limiting structure 25 is a protrusion structure provided on the sidewall of the photosensitive chip 2. A width of the protrusion structure matches a width of the mounting groove, so as to prevent the photosensitive chip 2 from shaking horizontally when being mounted in the mounting hole 13. It can be understood that in other embodiments, the first limiting structure 132 and the second limiting structure 25 may also be provided in other ways. For example, the first limiting structure 132 is a protrusion structure provided on the inner wall 131 of the mounting hole 13, and the second limiting structure 25 is a mounting groove provided on the sidewall 21 of the photosensitive chip 2.

As shown in FIG. 2, in this embodiment, the optical filter 4 is attached to the photosensitive chip 2, which can reduce a distance between the optical filter 4 and the photosensitive chip 2, thereby reducing the number of the reflections of light transmitted between the optical filter 4 and the photosensitive chip 2, so as to avoid the occurrence of light spots.

As shown in FIG. 2, in this embodiment, the support 5 includes a bottom surface 51 and a top surface 52 away from each other. The bottom surface 51 is connected to the substrate 1, and the top surface 52 is connected to the lens 20. The support 5 is provided with a first positioning structure 53, and the substrate 1 is provided with a second positioning structure 14. The first positioning structure 53 cooperates with the second positioning structure 14, such that the mounting position of the support 5 on the substrate 1 can be defined. Specifically, in this embodiment, the support 5 is a hollow structure with openings at both ends, that is, the support 5 also has a receiving cavity 54 extending from the bottom surface 51 to the top surface 52. The substrate 1 is provided with a groove 140, and the support 5 is mounted in the groove 140. A thickness of a sidewall of an end 540 of the support 5 located in the groove 140 is the same as a width of the groove 140. In this case, the sidewall of the end 540 of the support 5 located in the groove is the first positioning structure 53, and the groove 140 is the second positioning structure 14. Through this configuration, the thickness of the entire camera module 100 can also be reduced to a certain extent.

In addition, in this embodiment, after the support 5 cooperates with the substrate 1, the photosensitive chip 2 and the optical filter 4 are opposed to the receiving cavity 54 of the support 5. External light is transmitted through the lens 20, and is then transmitted from the receiving cavity 54 to the optical filter 4 and the photosensitive chip 2. Meanwhile, after the support 5 cooperates with the substrate 1, electronic elements, the first electrode 14, the second electrode 24 and the metal wires 7 on the substrate 1 are also located in the receiving cavity 54, and can be protected by the support 5, which improves the service life and safety performance of the camera module 100.

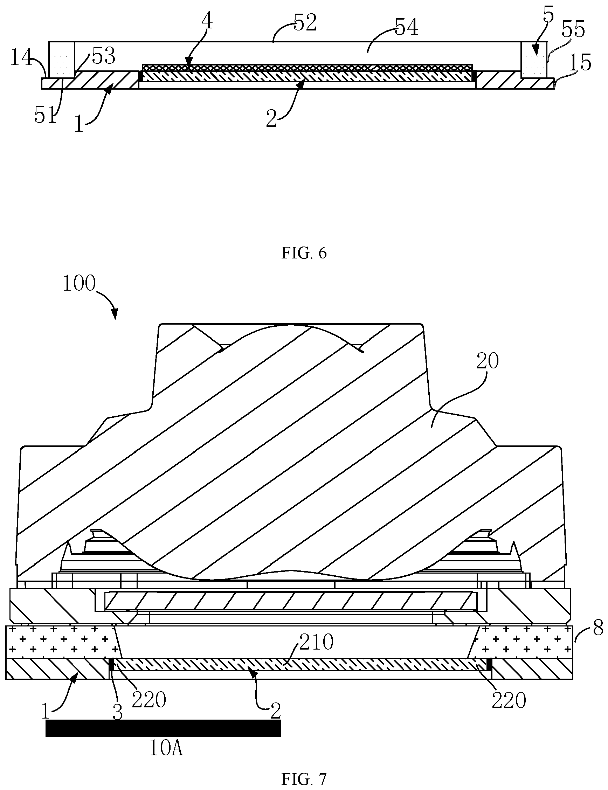

As shown in FIG. 6, in another embodiment, an outer sidewall of the groove 140 can also be omitted. In this case, the thickness of the middle portion of the substrate 1 is greater than the thickness of the outer peripheral portion of the substrate 1, that is, the substrate 1 is of a structure similar to a trapezoid. Further, the sidewall 15 of the substrate 1 may be coplanar with the sidewall 55 of the support 5.

As shown in FIG. 7, in another embodiment according to the present application, the base 10 is not provided with the support 5, but is provided with a packaging body 8. The packaging body 8 is provided between the substrate 1 and the lens 20 to connect the lens 20 and the substrate 1. That is, in this embodiment, the support 5 according to the above embodiments is replaced by the packaging body 8. The packaging body 8 is formed on the substrate 1, and is of a hollow structure with openings at both ends formed by applying and curing the glue on the substrate 1. The packaging body 8 covers the electronic elements, the first electrode 14, the second electrode 24, the metal wires 7 etc. on the substrate 1, so as to protect these elements. Meanwhile, the packaging body 8 further covers an edge of the photosensitive chip 2 to improve the connection strength between the photosensitive chip 2 and the substrate 1. Specifically, the photosensitive chip 2 includes a photosensitive region 210 and an edge region 220 located around the photosensitive region 210. The photosensitive region 210 is opposed to the lens 20, so as to receive the light transmitted from the lens 20. The packaging body 8 covers the edge region 220 of the photosensitive chip 2.

In addition, in this embodiment, the packaging body 8 and the connecting structure 3 may be integrally formed. That is, during the production process, the packaging body 8 and the connecting structure 3 may be simultaneously formed by applying the glue one time.

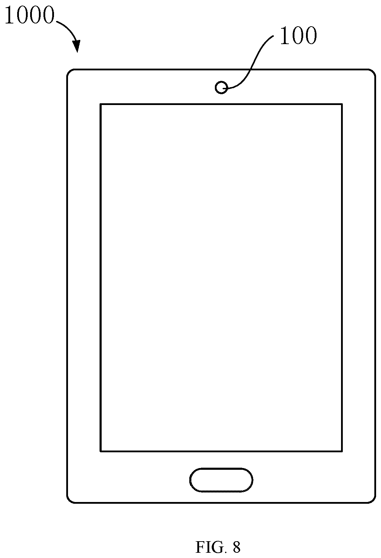

As shown in FIG. 8, the present application also provides an electronic device 1000. The electronic device 1000 utilizes the camera module 100 according to any of the above embodiments. The electronic device 1000 may be a terminal product such as a smart phone or a tablet computer.

The technical features of the above-described embodiments can be combined arbitrarily. To simplify the description, not all possible combinations of the technical features in the above embodiments are described. However, all of the combinations of these technical features should be considered as being fallen within the scope of the present application, as long as such combinations do not contradict with each other.

The foregoing embodiments merely illustrate some embodiments of the present application, and descriptions thereof are relatively specific and detailed. However, it should not be understood as a limitation to the patent scope of the present application. It should be noted that, a person of ordinary skill in the art may further make some variations and improvements without departing from the concept of the present application, and the variations and improvements falls in the protection scope of the present application. Therefore, the protection scope of the present application shall be subject to the appended claims.

## Claims

1. Abase configured to carry a lens, **characterized by**, comprising:
a substrate configured to be connected to the lens and provied with a mounting hole;
a photosensitive chip provided in the mounting hole and opposed to the lens, wherein a gap is formed between a sidewall of the photosensitive chip and an inner wall of the mounting hole; and
a connecting structure provided in the gap and connected to the photosensitive chip and the substrate, respectively, so as to fix the photosensitive chip on the substrate.

2. The base according to claim 1, wherein the substrate comprises a first surface and a second surface away from each other, the second surface is configured to be connected to the lens, the mounting hole is provided on the second surface and extends toward the first surface.

3. The base according to claim 2, wherein the photosensitive chip comprises an upper surface and a lower surface away from each other, the upper surface is opposed to the lens, a distance between the lower surface and the second surface is less than or equal to a depth of the mounting hole, and the distance between the lower surface and the second surface is greater than or equal to a distance between the upper surface and the lower surface.

4. The base according to claim 2, wherein the distance between the inner wall of the mounting hole and the sidewall of the photosensitive chip gradually decreases in a direction from the second surface to the first surface.

5. The base according to claim 2, wherein a thickness of the substrate is greater than or equal to a thickness of the photosensitive chip.

6. The base according to claim 1, wherein the substrate comprises a first surface and a second surface away from each other, the mounting hole extends from the second surface to the first surface.

7. The base according to claim 1, wherein the inner wall of the mounting hole is provided with a first limiting structure, and the sidewall of the photosensitive chip is provided with a second limiting structure, the first limiting structure cooperates with the second limiting structure to define a position of the photosensitive chip relative to the substrate in a circumferential direction of the mounting hole.

8. The base according to claim 1, wherein a shape of the mounting hole matches a shape of the photosensitive chip.

9. The base according to claim 1, wherein the connecting structure is a cured glue block filled in the gap.

10. The base according to claim 1, wherein the photosensitive chip and the mounting hole are coaxially arranged.

11. The base according to claim 1, wherein the substrate is a printed circuit board (PCB); the printed circuit board is provided with a first electrode pin, the photosensitive chip is provided with a second electrode pin, and the first electrode pin is electrically connected to the second electrode pin though a metal wire.

12. The base according to claim 1, further comprising an optical filter attached to the photosensitive chip.

13. The base according to claim 1, further comprising a support provided on the base and configured to connect the lens and the substrate.

14. The base according to claim 13, wherein the support is provided with a first positioning structure, and the substrate is provided with a second positioning structure, the first positioning structure cooperates with the second positioning structure, so as to define a mounting position of the support on the substrate.

15. The base according to claim 14, wherein the support is a hollow structure with openings at both ends, the substrate is provided with a groove, and the support is mounted in the groove, wherein an end of the support located in the groove is the first positioning structure, and the groove is the second positioning structure.

16. The base according to claim 1, further comprising a packaging body formed on the substrate and configured to connect the lens and the substrate.

17. The base according to claim 16, wherein the packaging body covers an edge of the photosensitive chip.

18. The base according to claim 16, wherein the packaging body and the connecting structure are integrally formed.

19. A camera module, **characterized by**, comprising:
a lens; and
a base connected to the lens, and comprising:
a substrate configured to be connected to the lens and provied with a mounting hole;
a photosensitive chip provided in the mounting hole and opposed to the lens, wherein a gap is formed between a sidewall of the photosensitive chip and an inner wall of the mounting hole; and
a connecting structure provided in the gap and connected to the photosensitive chip and the substrate, respectively, so as to fix the photosensitive chip on the substrate.

20. An electronic device, **characterized by**, comprising a camera module;
wherein the camera module comprises:
a lens; and
a base connected to the lens, and comprising:
a substrate configured to be connected to the lens and provied with a mounting hole;
a photosensitive chip provided in the mounting hole and opposed to the lens, wherein a gap is formed between a sidewall of the photosensitive chip and an inner wall of the mounting hole; and
a connecting structure provided in the gap and connected to the photosensitive chip and the substrate, respectively, so as to fix the photosensitive chip on the substrate.
